# EUROPEAN PATENT SPECIFICATION

(11) **EP 0 801 418 B1**
(45) Date of publication and mention of the grant of the patent: **26.09.2001**
(21) Application number: 97105617.1
(22) Date of filing: 04.04.1997
(51) Int. Cl.: H01L 21/027, H01L 21/28, H01L 21/335, H01L 29/423

(54) **Method for forming a T-shaped gate electrode in a semi-conductor device, and the T-shaped gate electrode**
Herstellungsverfahren einer T-förmigen Gate-Elektrode in einem Halbleiterbauelement, und die T-förmige Gate-Elektrode
Procédé de formation d'une électrode de grille en forme de T dans un dispositif semiconducteur et électrode de grille en forme de T

(30) Priority: 10.04.1996 JP 8801096
(43) Date of publication of application: 15.10.1997
(73) Proprietor: MURATA MANUFACTURING CO., LTD., Nagaokakyo-shi Kyoto-fu 226 (JP)
(72) Inventor: Sasaki, Hidehiko, Nagaokakyo-shi, Kyoto-fu (JP); Yokoi, Yasushi, Nagaokakyo-shi, Kyoto-fu (JP); Monden, Koji, Nagaokakyo-shi, Kyoto-fu (JP)
(74) Representative: Gossel, Hans K., Dipl.-Ing.

(56) References cited:
- EP-A- 0 539 688
- EP-A- 0 701 272
- US-A- 5 356 823
- TAKENAKA H ET AL: "0.15MUM T-SHAPED GATE FABRICATION FOR GAAS MODFET USING PHASE SHIFTLITHOGRAPHY" IEEE TRANSACTIONS ON ELECTRON DEVICES, vol. 43, no. 2, 1 February 1996, pages 238-244, XP000589311
- PATENT ABSTRACTS OF JAPAN vol. 012, no. 397 (E-672), 21 October 1988 & JP 63 137481 A (NEC CORP), 9 June 1988,
- PATENT ABSTRACTS OF JAPAN vol. 018, no. 658 (E-1643), 13 December 1994 & JP 06 260509 A (NEC CORP), 16 September 1994,
- PATENT ABSTRACTS OF JAPAN vol. 017, no. 230 (E-1361), 11 May 1993 & JP 04 360543 A (MITSUBISHI ELECTRIC CORP), 14 December 1992,

## Description

### BACKGROUND OF THE INVENTION

The present invention relates to a manufacturing method of T-shaped gate electrode in a semiconductor device, comprising the steps of: 1) forming a first resist on a semiconductor substrate on which source and drain electrodes are provided; 2) forming a first gate opening on said first resist between said source and drain electrodes; 3) deforming said first resist by baking; 4) forming a second resist overlaying said first resist and said first gate opening; 5) forming a second gate opening on said second resist above said first gate opening, said second gate opening being larger than said first gate opening; 6) depositing electrode metal for forming the T-shaped gate electrode on said second gate opening; and 7) removing said first and second resist.

To improve the performance of a field-effect transistor or the like, the length of a gate electrode needs to be reduced. However, simply forming the gate electrode to be thin increases the gate resistance, which increasingly deteriorates transistor characteristics. Accordingly, a T-shaped gate electrode structure in which the gate length is reduced and the gate cross-sectional area is enlarged to prevent an increase in the gate resistance has been used.

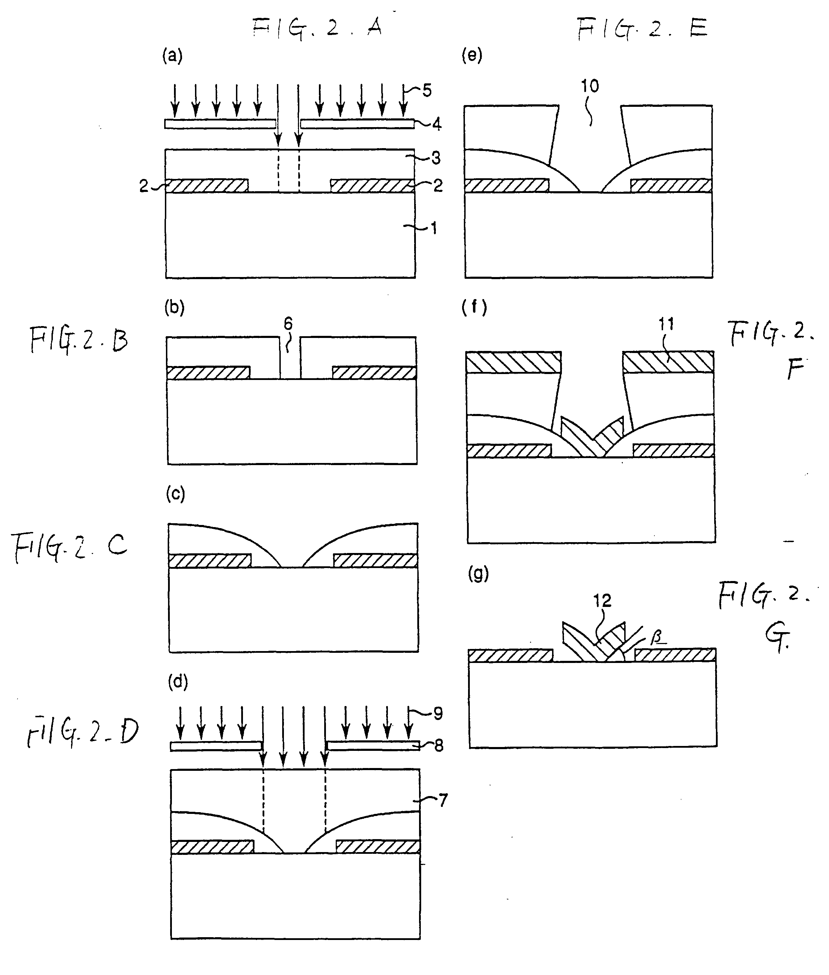

Figs. 2A to 2G show a method for forming a T-shaped gate electrode with a conventional two resist layers.

As shown in Fig. 2A, a source/drain electrode 2 is formed on a semiconductor substrate 1, and a first resist 3 is subsequently formed. As shown in Fig. 2B, exposure light 5 is emitted through a photomask 4 to expose the first resist 3, and a first gate opening 6 is subsequently formed by developing the exposed first resist 3. Successively, as shown in Fig. 2C, the first resist 3 is deformed by baking, at 180°C for 3 minutes for example, and as shown in Fig. 2D, a second resist 7 is formed, and exposure light 9 is emitted through a photomask 8 to expose the second resist 7. Subsequently, as shown in Fig. 2E, a second gate opening 10 is formed by developing the exposed second resist 7.

Finally, as shown in Fig. 2F, gate electrode metal 11 is deposited on the overall surface of the second resist 7, and subsequently, as shown in Fig. 2G, by using a lift-off technique for dissolving the first resist 3 and the second resist 7, the gate electrode metal 11 is removed to produce a T-shaped gate electrode. According to the above method, it is essential to bake the first resist 3 to cure (step shown in Fig. 2C) after patterning the first resist 3 so that the width of the first gate opening 6 in the first resist 3 is constant after the baking step.

However, the baking step causes deformation of the first resist 3, which greatly affects the shape of the finally obtained gate electrode. In other words, a rise angle β (shown in Fig. 2G) of the gate electrode is determined by the shape of the first resist 3. Thus, as the first resist 3 becomes deformed, the rise angle β decreases, so the distance between the gate electrode 12 and the semiconductor substrate 1 except for contact portion thereof narrows. Therefore, to obtain a T-shaped gate electrode in a semiconductor device which has a large rise angle, particularly 30 degrees or more, is difficult.

In the T-shaped gate electrode the space between the electrode 12 and the semiconductor 1 has capacitance, which is so-called parasitic capacitance. Enlarging the distance between the gate electrode 12 and the semiconductor substrate 1 reduces parasitic capacitance i.e., improve transistor characteristics such as a cut-off frequency, and so forth. In other words, the deformation of the first resist 3 increases parasitic capacitance i.e., deteriorate the transistor characteristics.

As means to prevent the deformation of the first resist 3, it is possible to use an ultraviolet curing technique which emits ultraviolet light to the first resist 3 to cure in advance after the step shown in Fig. 2B. However, the ultraviolet curing technique is not preferable because it requires expensive equipment and long processing time, which increases a cost of producing semiconductor devices.

### SUMMARY OF THE INVENTION

Accordingly, it is an object of the present invention to provide a manufacturing method of a T-shaped gate electrode of above mentioned kind, which prevents deformation of a first resist, and readily forms the T-shaped gate electrode having reduced parasitic capacitance.

According to the invention, the foregoing object is achieved through the provision of a manufacturing method above mentioned kind, which is characterized in that a pair of dummy openings are formed on said first resist in proximity to both sides of said first gate opening, and a pair of first resist convex portions are formed when said first resist are deformed by baking.

In the manufacturing method described above, a lift-off technique may be performed to remove said first and second resist.

Preferably, said first resist convex portions have a pattern such that said T-shaped gate electrode is formed being analogous to V-shape.

The T-shaped gate electrode may be formed such that a rise angle thereof is 30 degrees or more with respect to the surface of said semiconductor substrate. Preferably, said rise angle of said T-shaped gate electrode is 45 degrees or more. The second resist may be baked at a temperature lower than a temperature at which the first resist is baked.

The semiconductor device which has the T-shaped gate electrode may be a field effect transistor.

According to the invention, by forming the dummy openings in proximity to both sides of the first gate opening, deformation of the first resist can be prevented, and the first resist convex portions rising steeply can be formed between the first gate opening and the dummy openings. Thus, it is possible to finally form the T-shaped gate electrode which has a large rise angle with respect to the surface of the semiconductor substrate.

The reason why the second resist is preferably baked at a temperature lower than a temperature at which the first resist is baked is to prevent intermixing of the first resist and the second resist while they are being baked, and to prevent deformation of the first resist.

In the field-effect transistor in which the T-shaped gate electrode has a rise angle of 30 degrees or more with respect to the surface of the semiconductor surface, the distance between the gate electrode and the semiconductor substrate except for contact portion thereof can be increased, so that parasitic capacitance can be reduced, and a field-effect transistor with preferable characteristics such as a cut-off frequency and so forth can finally be obtained.

In the field-effect transistor in which the T-shaped gate electrode has a rise angle of 45 degrees or more, the parasitic capacitance can further be reduced to improve field-effect transistor characteristics.

### BRIEF DESCRIPTION OF THE DRAWINGS

- Figs. 1A to 1G: are charts illustrating a process for forming a T-shaped gate electrode using two resist layers according to an embodiment of the present invention.
- Figs. 2: are charts illustrating a process for forming a T-shaped gate electrode using two conventional resist layers.

### DESCRIPTION OF THE PREFERRED EMBODIMENT

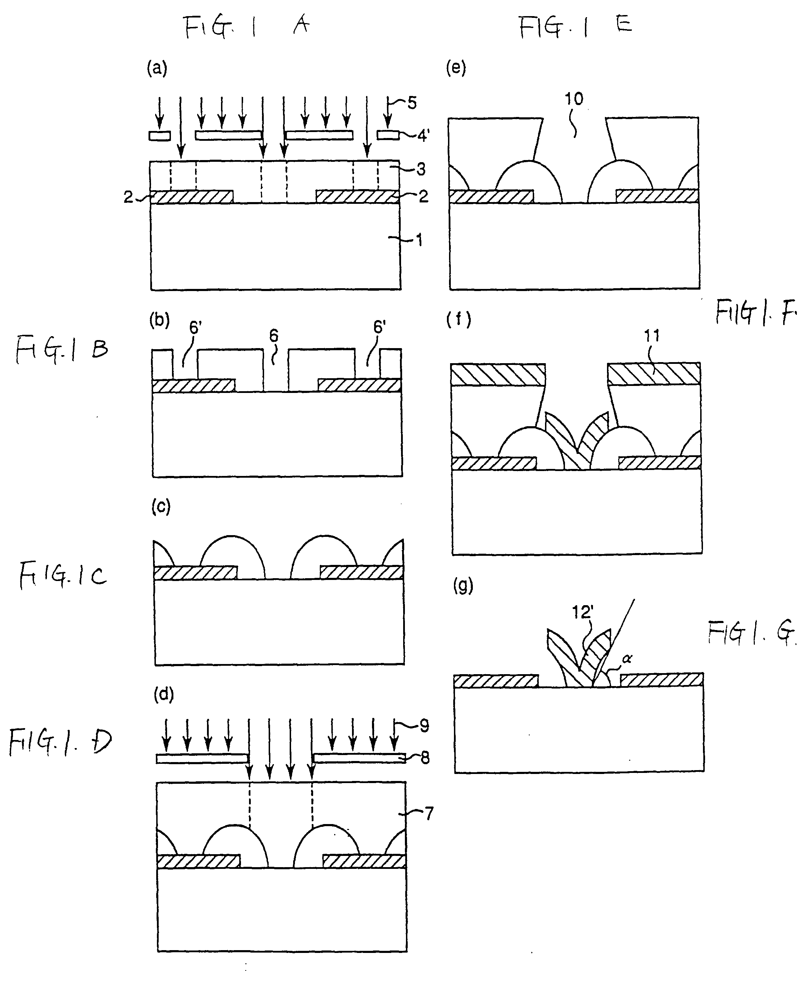

Figs. 1A to 1G show one embodiment of the present invention. The same reference numerals as those in Figs. 2A to 2G denote the same or corresponding portions. As shown in Fig. 1A, after a source/drain electrode 2 is formed on a semiconductor substrate 1, for example, a positive photoresist such as PFi26A (produced by Sumitomo Chemical Co., Ltd.) is coated to be approximately 1 µm thick by spin coating, and the coated photoresist is baked at 90°C for 90 seconds to form a first resist 3. Successively, by using an i-line stepper to emit exposure light 5 onto the first resist 3 through a photo mask 4' having a gate pattern and a dummy pattern with a pattern width of 0.5 µm, the first resist 3 is exposed.

Subsequently, as shown in Fig. 1B, by developing the first resist 3 with an ordinary alkaline developer (for example, SD-1 produced by Tokuyamasotatsu Co., Ltd.), a first gate opening 6 and dummy openings 6' are formed in the first resist 3. In order to prevent deformation of the resist while being baked during a successive step as shown in Fig. 1C by utilizing surface tension, the first resist pattern is formed so that, for example, when the first gate opening 6 is 0.5 µm wide, the distance between the first gate opening 6 and the dummy opening 6' is appropriately set to approximately 3 µm. The width of the dummy opening 6' may be arbitrary.

As shown in Fig. 1C, the first resist 3 is baked. The first resist 3 is appropriately baked by an air-circulating oven at 180°C for 15 minutes or by a hot plate at 180°C for 3 minutes. The baking softens the first resist 3, but its surface tension forms convex shapes (Fig. 1C) which rise steeply between the first gate opening and the dummy openings, which does not cause conventional broad deformation as shown in Fig. 2C.

The following Table 1 shows relationships of the thickness of the first resist 3 and the distance between the first gate opening 6 and the dummy opening 6' with respect to a rise angle α in a T-shaped gate electrode when the first gate opening 6 is 0.5 µm wide.

As apparent from the following Table 1, by controlling the thickness of the first resist 3 and the distance between the first gate opening 6 and the dummy opening 6', the rise angle α in the T-shaped gate electrode can be controlled.

When the gate electrode was formed without the dummy openings 6' under the same conditions as those in Table 1, the rise angle α was 25°.

**Table 1**

| Thickness of First Resist (µm) | Distance between Gate Opening and Dummy Opening (µm) | Rise Angle α ( ° ) |
|---|---|---|
| 1 | 2 | 90 |
| 1 | 3 | 80 |
| 1 | 4 | 65 |

Subsequently, as shown in Fig. 1D, similar to the conventional method, a second resist 7 is formed so as to include the first gate opening and to overlay the first resist convex portions which rise steeply, and exposure light 9 is emitted through a photomask 8 to expose the second resist 7. Since the second resist 7 preferably has an overhang shape (Fig. 1E) in which a lift-off technique is easily performed after development, the second resist 7 is preferably comprised of AZ5214E (produced by Hoechst Ltd.) by which the overhang shape is easily obtained.

As shown in Fig. 1E, by a conventional development process, a second gate opening 10 which is larger than the first gate opening 6 is formed on the second resist 7 above the first gate opening 6. As mentioned above, the second resist 7 preferably has the overhang shape.

Successively, as shown in Fig. 1F, a gate electrode metal 11 is formed by vacuum deposition on the sides of the convex portions of the first resist 3 which rise steeply from the bottom of the first gate opening 6 through the second gate opening 10 so as to comprise Ti of 100nm thick, Pt of 50nm and Au of 300nm.

Finally, as shown in Fig. 1G, by the so-called lift-off technique, the first resist 3 and the second resist 7 are dissolved and removed using an organic solvent or the like, and the gate electrode metal 11 on the second resist 7 is removed to provide a T-shaped gate electrode 12' which has a large rise angle compared with the conventional structure.

According to this embodiment, undesirable deformation of a first resist 3 in baking after the first resist 3 is formed can be prevented. The first resist 3 after baked can have convex shapes which rise steeply between the first gate opening 6 and the dummy openings 6', and the rise angle α of the finally obtained T-shaped gate electrode can be increased more than the rise angle β of the conventional T-shaped gate electrode. As a result, the parasitic capacitance generated between the semiconductor substrate 1 and the gate electrode 12' can be reduced. In addition, the process according to this embodiment do not require an expensive ultraviolet curing method, thus, the above-described advantages can be obtained at the same cost as that in the conventional manufacturing process.

## Claims

1. A manufacturing method of T-shaped gate electrode (12') in a semiconductor device, comprising the steps of
1) forming a first resist (3) on a semiconductor substrate (1) on which source and drain electrodes (2) are provided,
2) forming a first gate opening (6) on said first resist (3) between said source and drain electrodes (2),
3) deforming said first resist (3) by baking,
4) forming a second resist (7) overlaying said first resist (3) and said first gate opening (6),
5) forming a second gate opening (10) on said second resist (7) above said first gate opening (6), said second gate opening (10) being larger than said first gate opening (6),
6) depositing electrode metal (11) for forming the T-shaped gate electrode (12') on said second gate opening (10), and
7) removing said first and second resist (3,7),
**characterized in that**
a pair of dummy openings (6') are formed on said first resist (3) in proximity to both sides of said first gate opening (6), and a pair of first resist convex portions is formed when said first resist (3) is deformed by baking.

2. A manufacturing method of T-shaped gate electrode (12') in a semiconductor device according to Claim 1, **characterized in that** a lift-off technique is performed to remove said first and second resist (3,7).

3. A manufacturing method of T-shaped gate electrode (12') in a semiconductor device according to Claim 1 or 2, **characterized in that** said first resist convex portions have a pattern such that said T-shaped gate electrode (12') is formed being analogous to V-shape.

4. A manufacturing method of T-shaped gate electrode (12') in a semiconductor device according to Claim 3, **characterized in that**
said T-shaped gate electrode (12') is formed such that a rise angle thereof is 30 degrees or more with respect to the surface of said semiconductor substrate (1).

5. A manufacturing method of T-shaped gate electrode (12') in a semiconductor device according to Claim 4, **characterized in that**
said rise angle of said T-shaped gate electrode (12') is 45 degrees or more.

6. A manufacturing method of T-shaped gate electrode (12') in a semiconductor device according to one of Claims 1 to 5, **characterized in that**
said second resist (7) is baked at a temperature lower than a temperature at which said first resist (3) is baked.

7. A manufacturing method of T-shaped gate electrode (12') in a semiconductor device according to one of Claims 1 to 6, **characterized in that** said semiconductor device is a field effect transistor.

## Patentansprüche

1. Verfahren zur Herstellung einer T-förmigen Gate-Elektrode (12') in einem Halbleiterbauelement, wobei das Verfahren die folgenden Schritte umfaßt:
1) Ausbilden einer ersten Photolackschicht (3) auf einem Halbleitersubstrat (1), auf dem Source- und Drain-Elektroden (2) vorgesehen sind,
2) Ausbilden einer ersten Gate-Öffnung (6) auf der ersten Photolackschicht (3) zwischen den Source- und Drain-Elektroden (2),
3) Verformen der ersten Photolackschicht (3) durch Brennen,
4) Ausbilden einer zweiten Photolackschicht (7) über der ersten Photolackschicht (3) und der ersten Gate-Öffnung (6),
5) Ausbilden einer zweiten Gate-Öffnung (10) auf der zweiten Photolackschicht (7) über der ersten Gate-Öffnung (6), wobei die zweite Gate-Öffnung (10) größer ist als die erste Gate-öffnung (6),
6) Abscheiden von Elektrodenmetall (11) zur Ausbildung der T-förmigen Gate-Elektrode (12') auf der zweiten Gate-Öffnung (10), und
7) Entfernen der ersten und zweiten Photolackschicht (3, 7),
**dadurch gekennzeichnet, daß**
zwei Scheinöffnungen (6') auf der ersten Photolackschicht (3) in der Nähe beider Seiten der ersten Gate-Öffnung (6) ausgebildet sind, und zwei erste konvexe Photolackabschnitte ausgebildet werden, wenn die erste Photolackschicht (3) durch Brennen verformt wird.

2. Verfahren zur Herstellung einer T-förmigen Gate-Elektrode (12') in einem Halbleiterbauelement nach Anspruch 1, **dadurch gekennzeichnet, daß** eine Abhebetechnik angewandt wird, um die erste und zweite Photolackschicht (3, 7) zu entfernen.

3. Verfahren zur Herstellung einer T-förmigen Gate-Elektrode (12') in einem Halbleiterbauelement nach Anspruch 1 oder 2, **dadurch gekennzeichnet, daß** die ersten konvexen Photolackabschnitte ein solches Muster haben, daß die T-förmige Gate-Elektrode (12') analog einer V-Form ausgebildet wird.

4. Verfahren zur Herstellung einer T-förmigen Gate-Elektrode (12') in einem Halbleiterbauelement nach Anspruch 3, **dadurch gekennzeichnet, daß** die T-förmige Gate-Elektrode (12') so ausgebildet wird, daß ein Anstiegswinkel derselben mindestens 30 Grad zur Oberfläche des Halbleitersubstrats (1) beträgt.

5. Verfahren zur Herstellung einer T-förmigen Gate-Elektrode (12') in einem Halbleiterbauelement nach Anspruch 4, **dadurch gekennzeichnet, daß** der Anstiegswinkel der T-förmigen Gate-Elektrode (12') mindestens 45 Grad beträgt.

6. Verfahren zur Herstellung einer T-förmigen Gate-Elektrode (12') in einem Halbleiterbauelement nach einem der Ansprüche 1 bis 5, **dadurch gekennzeichnet, daß** die zweite Photolackschicht (7) bei einer Temperatur gebrannt wird, die niedriger ist als eine Temperatur, bei der die erste Photolackschicht (3) gebrannt wird.

7. Verfahren zur Herstellung einer T-förmigen Gate-Elektrode (12') in einem Halbleiterbauelement nach einem der Ansprüche 1 bis 6, **dadurch gekennzeichnet, daß** das Halbleiterbauelement ein Feldeffekttransistor ist.

## Revendications

1. Procédé de fabrication d'une électrode de grille en forme de T (12') dans un dispositif semiconducteur, comprenant les étapes consistant à
1) former un premier résist (3) sur un substrat semiconducteur (1) sur lequel des électrodes de source et de drain (2) sont prévues,
2) ménager une première ouverture de grille (6) dans ledit premier résist (3) entre lesdites électrodes de source et de drain (2),
3) déformer ledit premier résist (3) par cuisson,
4) former un second résist (7) recouvrant ledit premier résist (3) et ladite première ouverture de grille (6),
5) ménager une seconde ouverture de grille (10) dans ledit second résist (7) au-dessus de ladite première ouverture de grille (6), ladite seconde ouverture de grille (10) étant plus grande que ladite première ouverture de grille (6),
6) déposer du métal d'électrode (11) pour former l'électrode de grille en forme de T (12') sur ladite seconde ouverture de grille (10), et
7) enlever lesdits premier et second résists (3,7),
**caractérisé en ce que**
une paire d'ouvertures fictives (6') est formée sur ledit premier résist (3) à proximité des deux côtés de ladite première ouverture de grille (6), et une paire de portions convexes de premier résist est formée lorsque ledit premier résist (3) est déformé par cuisson.

2. Procédé de fabrication de l'électrode de grille en forme de T (12') dans un dispositif semiconducteur selon la revendication 1, **caractérisé en ce qu'**une technique d'arrachement est exécutée pour enlever lesdits premier et second résists (3,7).

3. Procédé de fabrication de l'électrode de grille en forme de T (12') dans un dispositif semiconducteur selon la revendication 1 ou 2, **caractérisé en ce que** lesdites portions convexes du premier résist ont un motif tel que ladite électrode de grille en forme de T (12') est formée en étant analogue à une forme en V.

4. Procédé de fabrication de l'électrode de grille en forme de T (12') dans un dispositif semiconducteur selon la revendication 3, **caractérisé en ce que** ladite électrode de grille en forme de T (12') est formée de façon qu'un angle d'élévation de celle-ci soit de 30 degrés ou plus par rapport à la surface dudit substrat semiconducteur (1).

5. Procédé de fabrication de l'électrode de grille en forme de T (12') dans un dispositif semiconducteur selon la revendication 4, **caractérisé en ce que** ledit angle d'élévation de ladite électrode de grille en forme de T (12') est de 45 degrés ou plus.

6. Procédé de fabrication de l'électrode de grille en forme de T (12') dans un dispositif semiconducteur selon l'une des revendications 1 à 5, **caractérisé en ce que** ledit second résist (7) est cuit à une température inférieure à la température à laquelle ledit premier résist (3) est cuit.

7. Procédé de fabrication de l'électrode de grille en forme de T (12') dans un dispositif semiconducteur selon l'une des revendications 1 à 6, **caractérisé en ce que** ledit dispositif semiconducteur est un transistor à effet de champ.
